(19)

Europäisches
Patentamt

European
Patent Office

Office européen
des brevets

(11)  **EP 3 428 973 A1**

(12)  **EUROPEAN PATENT APPLICATION**
published in accordance with Art. 153(4) EPC

(43) Date of publication:
**16.01.2019  Bulletin 2019/03**

(21) Application number: **17762626.4**

(22) Date of filing: **10.03.2017**

(51) Int Cl.:
*H01L 31/042* (2014.01)          *G02B 27/10* (2006.01)
*G02B 27/12* (2006.01)

(86) International application number:
**PCT/IB2017/051426**

(87) International publication number:
**WO 2017/153968 (14.09.2017 Gazette 2017/37)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority:  **11.03.2016  CO 16064118**

(71) Applicant: **Universidad Eafit
Medellín 050022 (CO)**

(72) Inventors:
• **BETANCUR MUÑOZ, Javier Mauricio
Medellín 050022 (CO)**
• **BETANCUR RODRIGUEZ, Mario Augusto
Medellín 050022 (CO)**
• **VELASQUEZ LOPEZ, Alejandro
Medellín 050022 (CO)**
• **MARULANDA BERNAL, Jose Ignacio
Medellín 050022 (CO)**

(74) Representative: **ABG Intellectual Property, S.L.
Avenida de Burgos, 16D
Edificio Euromor
28036 Madrid (ES)**

(54)  **COVERING WITH OPTOELECTRONIC ELEMENTS**

(57)  The present invention relates to a covering with optoelectronic elements, which uses a cover to optimize light distribution to absorb or emit optical radiation. The cover diverts optical radiation originating from external optical sources or optoelectronic elements contained in the covering, to maximize the absorption or dispersion of the optical radiation. The optoelectronic elements absorb or emit optical radiation, which is used to generate photovoltaic energy by using photovoltaic cells or to measure radiation by means of sensors of ultraviolet, infrared or visible radiation, inter alia, or to emit optical radiation by means of light-emitting elements such as LEDs, lasers, incandescent bulbs, and fluorescent lamps, inter alia. The cover and the optoelectronic elements are supported by a base that contains securing elements.

FIG. 1

EP 3 428 973 A1

**Description**

**1. Field of the invention**

The subject invention relates to coverings having optoelectronic elements used in absorbing or emitting optical radiation such as photovoltaic cells, ultraviolet, infrared or visible radiation sensors, LEDs, lasers, incandescent bulbs, fluorescent lamps, amongst others.

**2. Description of prior art**

Less available area to install solar farms is found in urban areas and thus vertical surfaces are sought which are characteristic of highly populated urban zones, generating power by use of photovoltaic technologies, both for the sale of excess electric power as well as for domestic consumption where nearby power generation is taken advantage of.

Therefore, the use of vertical surfaces found in urban buildings is found to be limited to the time exposure for solar energy collection, given light is found projected parallel to said surfaces the majority of the day, a situation generating little efficiency in energy collection.

In addition, all systems currently in existence pose several problems when being incorporated in buildings, particularly in vertical building facades. Mainly, they require metallic structures located externally to the facades in order to be installed, not only generating weight to the facade but also an additional process for panel installation. Secondly, they notably interfere with the esthetics and original architectural design given the reduced variety of sizes and shapes of commercially available solar panels.

One example of current solar panel installation systems on vertical building surfaces is found in US 8898968 B2, wherein a solar power module is disclosed for fitting against external building walls. The module is comprised of a base installed against the building, a front panel that receives a photovoltaic cell within having an aperture allowing the entrance of light to said photovoltaic cell. In addition, said front panel has a slope in order to take advantage of the most amount of light possible during the day. The system disclosed in the document, in addition to the slope of the photovoltaic cell, did not provide any other system that would help optimize solar light reception.

Another relevant document is US 20120247721 A1, wherein a wall module is disclosed which includes a power generation subset having a body and one or more photovoltaic power generation modules. Each power generation module includes one or more photovoltaic panels for converting light energy into electric energy, and means to secure the photovoltaic panel to the body. The wall module also incudes one or more circuits adapted in such a way as to allow for heat flow through said module. Each circuit is at least partially coupled with the power generation subset for thermal energy transfer between both by means of conduction, in order to moderate operational temperature of the photovoltaic panels. Although this system adapts to vertical surfaces of urban settings, it does not optimize solar light reception in any way.

Finally, WO 14097326 A1 discloses a brick comprising a main body, made of at least partially, of transparent material and having a boxed shape containing a photovoltaic cell and wherein its frontal face is convex in order to optimize solar light reception at times when said face is not entirely perpendicular to the brick.

There is an evident need for a modular system that optimizes solar light reception for power generation or that otherwise optimizes light emission from the inside of the system. In addition, a system that can be used as an architectural material and that allows being used in traditional construction is needed; complying with structural, power generation and esthetic requirements made by an architect.

**3. Brief description of the invention**

A covering with an optoelectronic element, comprised of a base, a cover and an optoelectronic element found encapsulated between the base and the cover. The cover has an internal surface, an external surface and a translucent propagation medium contained between said surfaces. In addition, the translucent propagation medium must have a refraction index equal or greater than 1 and the internal (4) and external (5) surfaces may be shaped in different ways so as to foster the optimization of optical radiation emission or absorption.

The covering is particularly characterized in that refracted light rays and the internal surface normal form an angle between 0° and 48°. Thus, both optical radiation that the element absorbs as well as optical radiation that the element emits can be optimized.

**4. Brief description of the drawings**

FIG. 1 illustrates an isometric view of the general configuration of the invention.

FIG. 2 illustrates a cutaway view of the covering having an optoelectronic element.

FIG. 3 illustrates an exploded view of an embodiment of the invention.

FIG. 4 illustrates an isometric view of an embodiment of the invention.

FIG. 4A illustrates a cross-section view of an embodiment of the invention.

FIG. 4B illustrates a longitudinal view of an embodiment of the invention.

FIG. 5 illustrates an isometric view of an embodiment of the invention.

FIG. 6 illustrates an isometric view of an embodiment of the invention.

FIG. 6A illustrates a cross-section view of an embodiment of the invention.

FIG. 7 illustrates a cross-section of an embodiment of the invention.

FIG. 8 illustrates a cross-section of an embodiment of the invention.

## 5. Detailed description of the invention

The subject invention corresponds to a covering having optoelectronic elements, designed to absorb or emit optical radiation, having several purposes, namely: photovoltaic power generation, electromagnetic radiation readings, or optical radiation generation for lighting purposes.

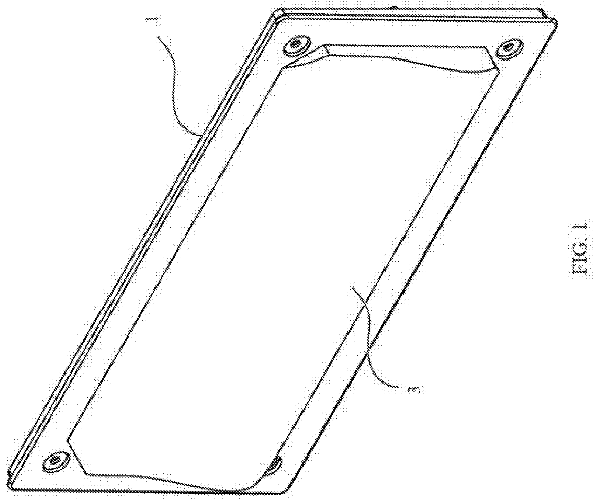

Making reference to FIG. 1, the covering having optoelectronic elements comprises:

- a base (1);
- an optoelectronic element (2); and
- a cover (3); wherein the optoelectronic element (2) is found encapsulated between the base (1) and the cover (3).

The optoelectronic element (2) is selected from a group comprised of photovoltaic cells, LEDs, incandescent lamps, lasers, laser diodes, photocells, thermocells, photoresistors, photodiodes, fluorescent light sources, gallium solar cells, and combinations thereof.

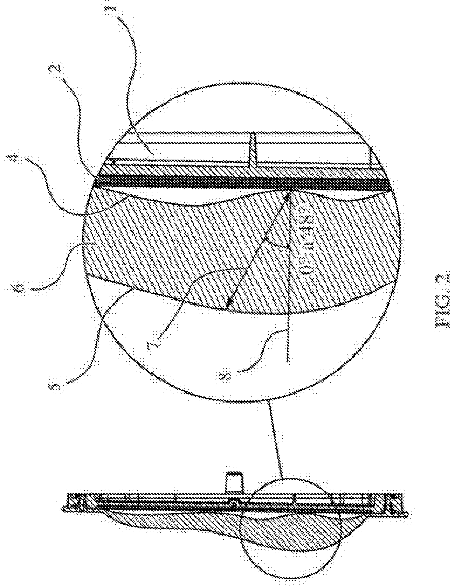

Furthermore, the cover (3) is manufactured from a material selected from a group comprising glass, translucent thermoplastics, translucent ceramics, thermoplastic polymers, thermostable polymers, polycarbonate and combinations thereof. Making reference to FIG. 2, the cover (3) has an internal surface (4) and an external surface (5) in between which a translucent propagation medium (6) is found which must have a refractive index greater than or equal to 1, and wherein the optoelectronic element (2) absorbs or emits optical radiation. The purpose of the cover (3) is to refract the optical radiation coming from outside shining on the external surface (5), or to refract the light radiation emitted by the optoelectronic element (2) shining on the internal surface (4). Both for absorption or emission of light radiation, the cover- (3) refracted light rays (7) must comply with the condition of forming a 0 to 48 degree angle with a perpendicular line to the internal surface (4), which from here on we will call the internal surface normal (8).

In an embodiment of the invention, the cover (3) is made of polycarbonate, which is a transparent thermoplastic material having a refractive index of 1.585. Likewise, it may be injected into molds and thereby, able to generate both in the internal surface (4) and external surface (5), certain shapes that foster light refraction, either light emitted from the inside of the covering having optoelectronic elements or received from the outside by the covering having optoelectronic elements.

In addition, in some embodiments of the invention, the material used to make the cover (3) is mixed with additives selected from the group comprising colorants and pigments, light diffusors, flame retardants, smoke suppressors, light stabilizers, infrared absorbers, ultraviolet absorbers, and optical brightener, among others. One example of the use of said additives is the use of pigments in order to generate particular esthetic effects, in the case where an optoelectronic (2) element generating light is used. Furthermore, light stabilizing additives and optical brighteners optimize optical radiation received by the element as well as optical radiation emitted by the element. Finally, infrared radiation absorbing additives are used for heat protection which can be generated within the element and that would affect the optoelectronic element (2).

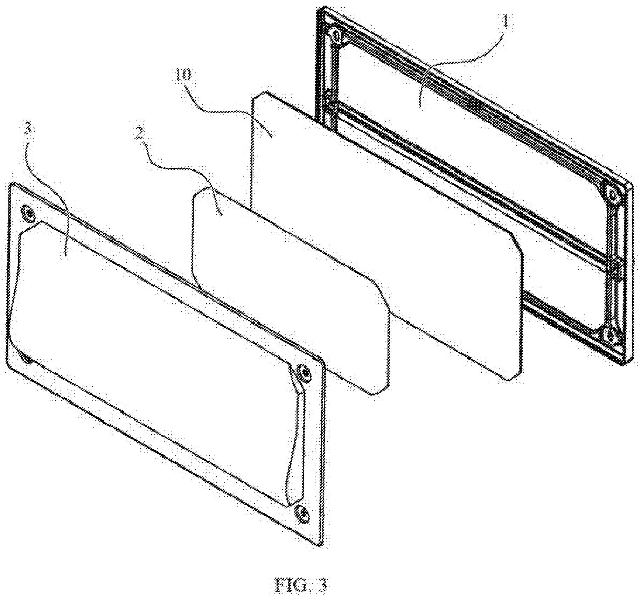

Making reference to FIG. 3, in an embodiment of the invention, the base (1) has a plate (10) made of flexible material that supports the optoelectronic element (2) and exerts pressure thereon, thus making it come into contact with the cover (3) and additionally working as a shock absorbing element in order to protect the optoelectronic element (2) from any strike the cover (3) might sustain.

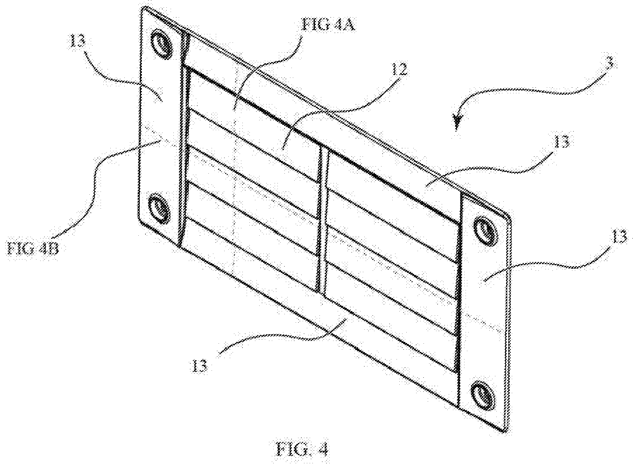

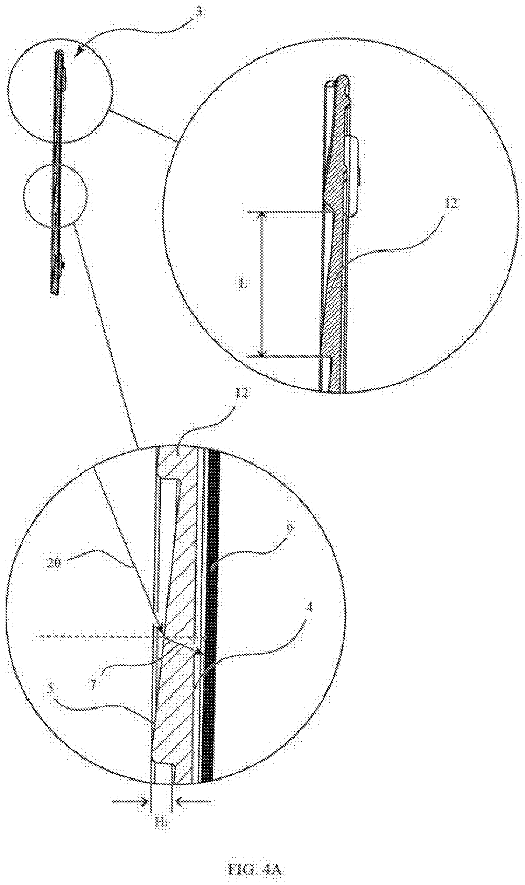

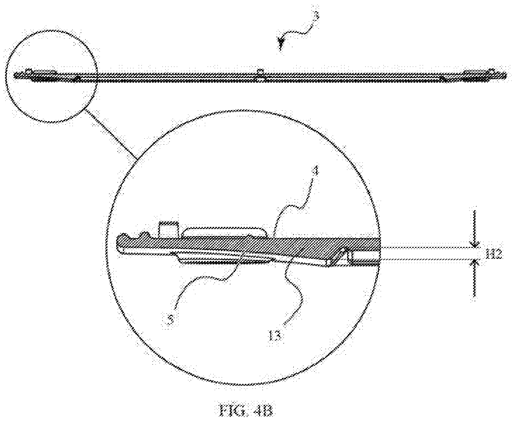

In an embodiment of the invention, and making reference to FIG. 4, the optoelectronic element (2) absorbs optical radiation, particularly a photovoltaic cell (9). In addition, the external surface (5) of the cover (3) shows a ridged profile (12), as shown in the cross-section view of FIG. 4A, located vertically and described by the following equation:

$$ y = H_1\big(u_{-2}(x) - u_{-2}(x\text{-}L) - Lu_{-1}(x\text{-}L)\big) $$

where $u_{-2}$ is the ramp function, $u_{-1}$ is the square wave function, L is the length of one of the ridged profile (12) ridges and $H_1$ is the height of the ridges; x, y are spatial variables measured in millimeters.

Each one of the ridged profile (12) ridges has a certain height $H_1$ and length L. The purpose of the ridged profile (12) ridges is to refract the solar light rays (20) making so that the refracted light rays (7) shine on the internal surface (4) of the cover (3) at an angle with the internal surface normal (8) between 0º and 48º, after passing through the translucent propagation medium (6).

In an embodiment of the invention, making reference to FIG. 4B, the cover (3) also has slopes (13) on each of its edges, defined by the following equation:

$$v = H_2u^2$$

wherein $H_2$ represents the maximum height of slope (13); v and u are spatial variables measured in millimeters. When light radiation sheds on slopes (13), these refract the light directing it towards the optoelectronic element (2).

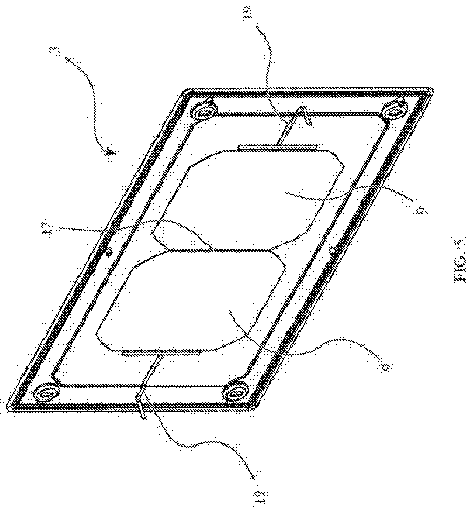

Making reference to FIG. 5, in an embodiment of the invention, the optoelectronic (2) element has two photovoltaic cells (9), contacting the internal surface (4) of the cover (3). The solar optical radiation is refracted by the external surface (5) of the cover (3) propagating through the translucent medium (6) until it reaches the internal surface (4) of the cover (3), in such a way that the angle of incidence of the refracted rays (7) on the photovoltaic cells (9) ranges between 0º and 48º with respect to the internal surface normal (4). The photovoltaic cells (9) are interconnected by a structural conductive sheet (17), which apart from connecting them electrically, it joins them structurally and makes them work as one. The electrical connection towards the outside of the cells, is carried out using conductive elements (19) which stand out past the edges of the photovoltaic cells (9) joined by the structural conductive sheet (17) and which shall become the external connections of the covering having optoelectronic elements, which in the end allows generating an array of coverings having optoelectronic elements side by side and which are interconnected.

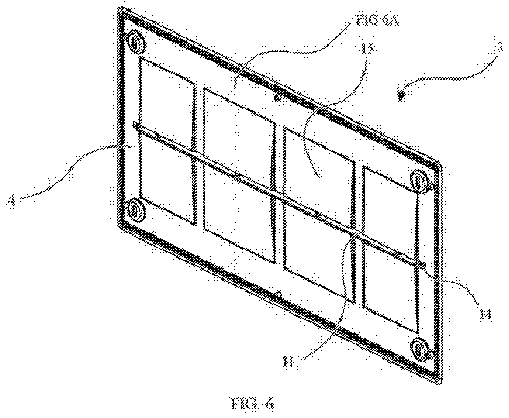

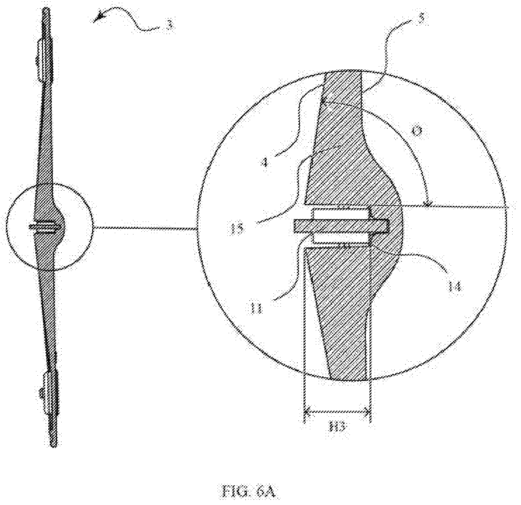

In an embodiment of the invention, the optoelectronic element comprises a system of LED lights (11) for optical radiation emission. The cover (3), as illustrated in FIG. 6, shows a housing (14) on the internal surface (4) for containing the LED lights (11) and a series of wedges (15) on the internal surface (4), thus generating an embossment. Therefore, as illustrated in FIG. 6A, light emitted by the LED lights (11) shine directly on the housing surface (14) designated with height $H_3$, said light refracting on the internal surface (4) of the cover (3) and experiencing total internal reflection within the portion of the internal surface (4) corresponding to the wedges (15) having a slope $\Phi$. This would make for the distribution of the emitted optical radiation for lighting purposes to be uniform. It is worth explaining that in this embodiment, $H_3$ is greater than or equal to 3 mm and slope $\Phi$ is greater than or equal to 1º.

In conclusion, it can be noted how the wedges (15), in addition to generating the housing (14), are designed to uniformly refract light generated by LED lights (11) and thus optimize light emitted by them, thanks to the available greater to lesser slope.

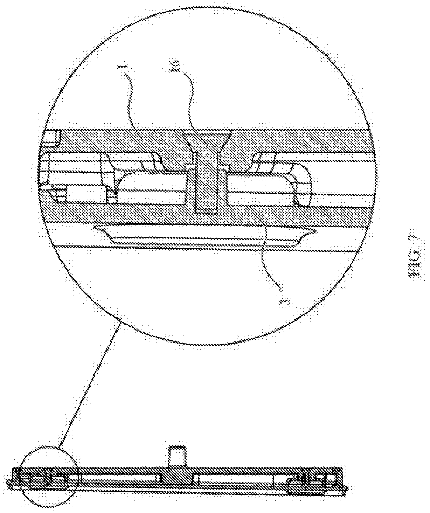

In an embodiment of the invention, making reference to FIG. 7, the base (1) and the cover (3) are put together using a chemical or mechanical assembly (16).

Using this assembly, the optoelectronic element (2) is protected from the exterior environment. In an embodiment of the invention, said chemical or mechanical assembly (16) is possible by means of a screw joining the base (1) and the cover (3). Likewise, the chemical or mechanical assembly (16) can also be possible using a snap fit system, considering the base (1) and the cover (3) can be made out of thermoplastics.

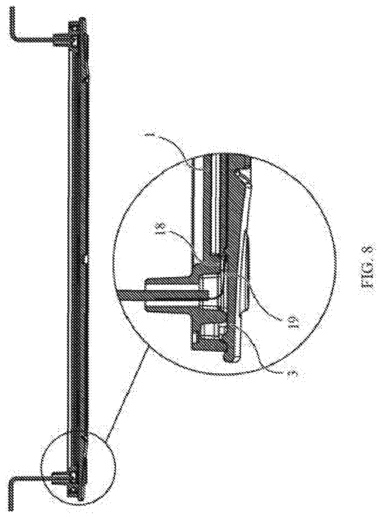

Making reference to FIG. 8, in an embodiment of the invention the conductor elements (19) are fixed using a mechanical binding element (18), which comprises a lump on the base (1), or could just be part of the cover (3). This lump puts pressure on the conductor element (19) making it stand still and avoiding the optoelectronic element's (2) position to be affected in the event any of said conductor elements (19) suffers any sort of pull.

## Claims

1. A covering having an optoelectronic element, comprising:

   a. a base (1);
   b. a cover (3) having an internal surface (4), an external surface (5) and a translucent propagation medium having a refraction index greater than or equal to 1 (6) contained between the internal surface (4) and the external surface (5);
   c. an optoelectronic element (2) encapsulated between the base (1) and the cover (3); and

   wherein the angle between the refracted light rays (7) and the internal surface normal (8) ranges between 0° and 48°.

2. The covering having an optoelectronic element of claim 1, **characterized in that** said optoelectronic element (2) is selected from the group comprising photovoltaic cells, LEDs, incandescent lamps, lasers, laser diodes, photocells, thermocells, photoresistors, photodiodes, fluorescent light sources, gallium solar cells, and combinations thereof.

3. The covering having an optoelectronic element of claim 1, **characterized in that** said optoelectronic element (2) is a photovoltaic cell (9).

4. The covering having an optoelectronic element of claim 1, **characterized in that** said optoelectronic element (2) installed on the base (1) is supported by a flexible material plate (10).

5. The covering having an optoelectronic element of claim 1, **characterized in that** said optoelectronic element (2) are LED lights (11).

**6.** The covering having an optoelectronic element of claim 1, **characterized in that** the cover (3) is made of a material selected from a group comprised of glass, translucent thermoplastics, translucent ceramics, thermoplastic polymers, thermostable polymers, and combinations thereof.

**7.** The covering having an optoelectronic element of claim 1, **characterized in that** the cover (3) has a ridged profile (12) on its external surface (5).

**8.** The covering having an optoelectronic element of claim 1, **characterized in that** the cover (3) has a slope (13) on its edges.

**9.** The covering having an optoelectronic element of claim 7, wherein each ridge in the ridged profile (12) is described with the equation

$$y = H_1(u_{-2}(x) - u_{-2}(x\text{-}L) - Lu_{-1}(x\text{-}L))$$

**10.** The covering having an optoelectronic element of claim 8, wherein the slope (13) is described with the equation

$$v = H_2 u^2$$

**11.** The covering having an optoelectronic element of claim 1, **characterized in that** the cover (3) has a housing (14) on its internal surface (5) for the optoelectronic elements (2).

**12.** The covering having an optoelectronic element of claim 1, **characterized in that** the cover (3) has a wedge (15) on its internal surface (5).

**13.** The covering having an optoelectronic element of claim 1, **characterized in that** the base (1) and cover (3) are secured using a chemical or mechanical assembly system (16).

**14.** The covering having an optoelectronic element of claim 1, **characterized in that** the optoelectronic element (2) are two photovoltaic cells (9) which interconnect by means of a structural conductive sheet (17).

**15.** The covering having an optoelectronic element of claim 6, **characterized in that** the material of cover (3) is found mixed together with additives selected from the group comprising colorants and pigments, light diffusors, flame retardants, smoke suppressors, light stabilizers, infrared absorbers, ultraviolet absorbers, and optical brighteners, among others.

**16.** The covering having an optoelectronic element of claim 1, **characterized in that** it has a mechanical binding element (18) that secures the conductive elements (19).

FIG. 1

FIG. 2

FIG. 3

FIG. 4A

FIG. 4B

FIG. 4

FIG. 4A

FIG. 4B

FIG. 5

FIG. 6A

FIG. 6

FIG. 6A

FIG. 7

FIG. 8

## INTERNATIONAL SEARCH REPORT

| International application No. |
| --- |
| PCT/IB2017/051426 |

**A.    CLASSIFICATION OF SUBJECT MATTER**

(CIP) H01L31/042; G02B27/10, 27/12   (2017.01)

According to International Patent Classification (IPC) or to both national classification and IPC

**B.    FIELDS SEARCHED**

Minimum documentation searched (classification system followed by classification symbols)

(CIP) H01L31/042; G02B27/10, 27/12       (CPC) Y02B10/00, 10/10, 10/12; Y02E10/00, 10/50

Documentation searched other than minimum documentation to the extent that such documents are included in the fields searched

Electronic data base consulted during the international search (name of data base and, where practicable, search terms used)

INAPI, ESP@ACENET, EPOQUE, THOMSON, GOOGLE PATENTS

**C.    DOCUMENTS CONSIDERED TO BE RELEVANT**

| Category* | Citation of document, with indication, where appropriate, of the relevant passages | Relevant to claim No. |
| --- | --- | --- |
| X<br>Y | US20090296188(A1) (THE BOARD OF TRUSTEES OF THE UNIVERSITY OF ILLINOIS), 03-12-2009<br>Description and figures 1-4 and 6 | 1-2, 4-8, 11-13, 16<br>3, 9-10, 14-15 |
| Y | WO2009098241(A1) (OERLIKON TRADING AG), 13-08-2009, Description and figures 2, 4 and 5 | 3, 9-10, 14-15 |
| A | CN101345267(A) (YI LI), 14-01-2009<br>Abstract and figure 1 | |
| A | CN101752276(A) (TESA AG.), 23-06-2010<br>Abstract and figures 1-3 | |
| A | DE102011101433(A1) (TECHNISCHE UNIVERSITAT DRESDEN),13-12-2012<br>Abstract and figures 1-4 | |

☐  Further documents are listed in the continuation of Box C.       ☒   See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 03 May 2017 (03.05.2017) | 19 June 2017 (19.06.2017) |

| Name and mailing address of the ISA/ CL | Authorized officer |
| --- | --- |
| Facsimile No. | Telephone No. |

Form PCT/ISA/210 (second sheet) (January 2015)

**INTERNATIONAL SEARCH REPORT**
Information on patent family members

| International application No. |
| --- |
| PCT/IB2017/051426 |

| | | | |
| --- | --- | --- | --- |
| US20090296188(A1) | 03-12-2009 | US7940457 (B2) | 10-05-2011 |
| | | WO2009146371(A1) | 03-12-2009 |
| WO2009098241(A1) | 13-08-2009 | NONE | |
| CN101345267(A) | 14-01-2009 | CN101345267(B) | 07-03-2012 |
| CN101752276(A) | 23-06-2010 | CN101752276(B) | 02-07-2014 |
| | | CA2688618(A1) | 16-06-2010 |
| | | DE102008062130(A1) | 17-06-2010 |
| | | EP2200105(A2) | 23-06-2010 |
| | | EP2200105(B1) | 28-09-2011 |
| | | EP2200105(A2) | 01-05-2013 |
| | | JP2010144169(A) | 01-07-2010 |
| | | KR20100069624(A) | 24-06-2010 |
| | | TW201029077(A) | 01-08-2010 |
| | | US2010148127(A1) | 17-06-2010 |
| DE102011101433 (A1) | 13-12-2012 | NONE | |

Form PCT/ISA/210 (patent family annex) (January 2015)

**EP 3 428 973 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 8898968 B2
- US 20120247721 A1
- WO 14097326 A1